# FASCICULE DE BREVET EUROPEEN

(11) **EP 3 367 770 B1**
(45) Date de publication et mention de la délivrance du brevet: **24.07.2019**
(21) Numéro de dépôt: 18158948.2
(22) Date de dépôt: 27.02.2018
(51) Int. Cl.: H05K 7/20, H01L 23/367, H01L 25/16

(54) **MODULE DE PUISSANCE AVEC SYSTÈME DE REFROIDISSEMENT DES CARTES ÉLECTRONIQUES**
LEISTUNGSMODUL MIT KÜHLSYSTEM DER ELEKTRONISCHEN KARTEN
POWER MODULE WITH COOLING SYSTEM FOR ELECTRONIC CARDS

(30) Priorité: 28.02.2017 FR 1751602
(43) Date de publication de la demande: 29.08.2018
(73) Titulaire: ALSTOM Transport Technologies, 93400 Saint-Ouen (FR)
(72) Inventeur: AUDEMAR, Christophe, 65310 HORGUES (FR)
(74) Mandataire: Lavoix

(56) Documents cités:
- EP-A1- 2 861 048
- EP-A2- 2 658 359
- US-A1- 2011 181 105

## Description

La présente invention concerne un module de puissance du type comportant : des équipements électriques, au moins une première et une deuxième cartes électroniques, et un dispositif de refroidissement, propre à évacuer de la chaleur dissipée par lesdits équipements électriques et cartes électroniques.

Les équipements électriques des modules de puissance, tels que des packs IGBT, sont susceptibles de dégager une chaleur importante en cours de fonctionnement. Les modules de puissance sont donc typiquement équipés de dispositifs de refroidissement, comme décrits par exemple dans le document US2011/0181105.

Les cartes électroniques de commande des équipements électriques sont typiquement sensibles aux températures élevées. Afin que lesdites cartes résistent à la chaleur émise par les composants du module, les solutions techniques habituelles consistent à adapter la technologie desdites cartes afin que ces dernières restent fonctionnelles aux températures élevées.

La présente invention a pour but de proposer une configuration du module qui protège les cartes électroniques des plus hautes températures, ce qui permet de prolonger leur durée de vie tout en utilisant des technologies moins onéreuses.

A cet effet, l'invention a pour objet un module de puissance du type précité, dans lequel : le dispositif de refroidissement comporte une première et une deuxième surfaces thermiquement isolées l'une de l'autre, les équipements électriques étant en contact thermique avec la première surface et à l'écart de la deuxième surface ; la première carte électronique est fixée à un équipement électrique, ladite première carte électronique étant thermiquement reliée à la deuxième surface du dispositif de refroidissement par un drain thermique ; et la deuxième carte électronique est disposée proche de la deuxième surface du dispositif de refroidissement ou au contact de ladite deuxième surface.

Suivant d'autres aspects avantageux de l'invention, le module de puissance comporte l'une ou plusieurs des caractéristiques suivantes, prises isolément ou suivant toutes les combinaisons techniquement possibles :
- les première et deuxième surfaces du dispositif de refroidissement sont sensiblement coplanaires ;
- le dispositif de refroidissement comporte : un panneau de refroidissement, une première face dudit panneau formant les première et deuxième surfaces du dispositif de refroidissement ; et des ailettes de ventilation, fixées à une seconde face du panneau de refroidissement ;
- chacune des première et deuxième surfaces est formée d'un matériau thermiquement conducteur, le panneau de refroidissement comportant en outre une bande d'un matériau thermiquement isolant, séparant lesdites première et deuxième surfaces ;
- le panneau de refroidissement comporte au moins une fente séparant les première et deuxième surfaces, lesdites première et deuxième surfaces étant reliées l'une à l'autre au niveau des extrémités de ladite fente ;
- le drain thermique comporte une bande d'un matériau thermiquement conducteur, une première et une seconde extrémités de ladite bande étant en contact thermique, respectivement avec la première carte électronique et avec la deuxième surface ;
- un contact thermique entre la première carte électronique et la première extrémité du drain thermique est assuré par une couche de pâte ou de mousse thermiquement conductrice ;
- le module de puissance comporte au moins une paroi thermiquement isolante disposée entre la deuxième carte électronique et un équipement électrique ;
- une face de la paroi thermiquement isolante, orientée vers l'équipement électrique, est recouverte d'une couche d'un matériau déflecteur de rayonnement infrarouge.

L'invention sera mieux comprise à la lecture de la description qui va suivre, donnée uniquement à titre d'exemple non limitatif et faite en se référant aux dessins sur lesquels :
- la figure 1 est une vue schématique, en coupe, d'un module de puissance selon un premier mode de réalisation de l'invention ; et
- la figure 2 est une vue schématique partielle d'un module de puissance selon un deuxième mode de réalisation de l'invention.

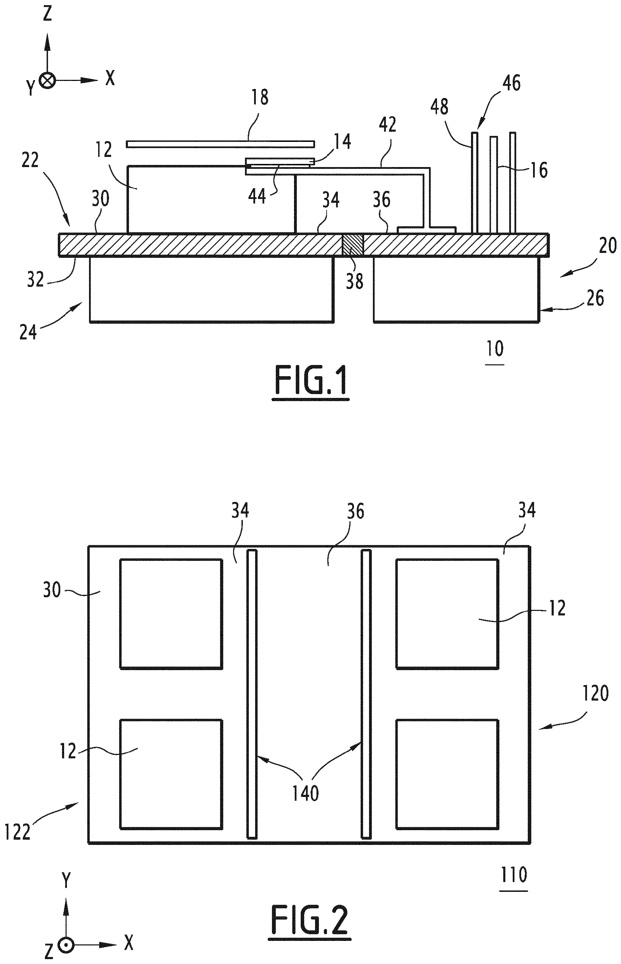

La figure 1 représente un module de puissance 10 selon un premier mode de réalisation de l'invention. La figure 2 représente partiellement un module de puissance 110 selon un premier mode de réalisation de l'invention.

Les modules de puissance 10 et 110 seront décrits simultanément, les éléments communs étant désignés par les mêmes numéros de référence.

Le module de puissance 10, 110 comprend des équipements électriques 12 et au moins une première 14 et une deuxième 16 cartes électroniques. Le module de puissance 10, 110 comprend en outre un bus barre 18. Les cartes électroniques 14, 16 et le bus barre 18 ne sont pas représentées sur la figure 2.

Le module de puissance 10, 110 comprend en outre un dispositif de refroidissement 20, 120, propre à évacuer de la chaleur dissipée par les équipements électriques 12 et les cartes électroniques 14, 16.

Les équipements électriques 12 sont de type composants électroniques de puissance, tels que des composants IGBT (transistor bipolaire à grille isolé). Les équipements électriques 12 sont notamment susceptibles de dégager une chaleur importante en cours de fonctionnement.

Les cartes électroniques 14, 16, représentées de manière schématique sur la figure 1, comprennent de manière classique un support et une pluralité de composants électroniques reliés audit support. Les composants électroniques sont également susceptibles de dégager de la chaleur en cours de fonctionnement. Par ailleurs, ces composants électroniques sont généralement sensibles aux températures élevées.

Dans les modes de réalisation des figures 1 et 2, le dispositif de refroidissement 20, 120 est de type radiateur à ailettes. Plus précisément, le dispositif de refroidissement 20, 120 comporte un panneau de refroidissement 22, 122 et des ailettes de ventilation 24, 26. Lesdites ailettes 24, 26 ne sont pas visibles sur la figure 2.

Le panneau de refroidissement 22, 122 est sensiblement plan. On considère une base orthonormée (X, Y, Z), le panneau de refroidissement 22, 122 étant sensiblement disposé dans un plan (X, Y).

Le panneau de refroidissement 22, 122 comporte une première 30 et une seconde 32 faces. Les ailettes de ventilation 24, 26 sont fixées à ladite seconde face 32.

La première face 30 du panneau de refroidissement 22, 122 comporte une première surface 34, dite « zone chaude », et une deuxième surface 36, dite « zone froide ». Les première 34 et deuxième 36 surfaces sont thermiquement isolées l'une de l'autre.

Dans le mode de réalisation de la figure 1, chacune des première 34 et deuxième 36 surfaces est formée d'un matériau thermiquement conducteur et le panneau de refroidissement 22 comporte en outre une bande 38 d'un matériau thermiquement isolant, séparant lesdites première 34 et deuxième 36 surfaces. Par ailleurs, les ailettes 24, 26 forment deux groupes situés à l'écart l'un de l'autre. Un premier groupe d'ailettes 24 est fixé à la première surface 34, un deuxième groupe d'ailettes 26 est fixé à la deuxième surface 36. De préférence, chaque groupe d'ailettes 24, 26 est réalisé d'une pièce avec la surface 34, 36 du panneau à laquelle il est fixé.

Dans le mode de réalisation de la figure 2, le panneau de refroidissement 122, représenté en vue de dessus, est formé d'une pièce. Ledit panneau a la forme d'un rectangle dont les côtés s'étendent selon les directions X et Y. La première surface 34 comporte deux parties situées aux extrémités du panneau selon X, la deuxième surface 36 étant disposée entre lesdites deux parties. Le panneau de refroidissement 122 comporte deux fentes 140 s'étendant selon Y et séparant la deuxième surface 36 de chaque partie de la première surface 34. Lesdites première 34 et deuxième 36 surfaces sont néanmoins reliées l'une à l'autre au niveau des extrémités des fentes 140.

En variante non représentée, il est possible d'assembler mécaniquement deux radiateurs avec un joint non conducteur au milieu.

Les équipements électriques 12 sont fixés à la première surface 34, en contact thermique avec ladite première surface dite « zone chaude ». La deuxième surface 36, dite «zone froide », n'est pas en contact avec les équipements électriques 12. Ladite deuxième surface 36 est utilisée pour refroidir spécifiquement les cartes électroniques 14, 16 afin de leur garantir une protection contre les hautes températures.

Plus précisément, pour des raisons fonctionnelles, la première carte électronique 14 est disposée à proximité d'un équipement électrique 12. Comme visible sur la figure 1, ladite première carte électronique 14 est donc fixée audit équipement électrique.

Le bus barre 18, ou jeu de barre, est un conducteur électrique et est amené à se trouver à des températures élevées. Le bus barre 18 est disposé au-dessus de la première carte électronique 14, à proximité de ladite carte.

La première carte électronique 14 est thermiquement reliée à la deuxième surface 36 du panneau de refroidissement 22, 122, par un drain thermique 42. Le drain thermique 42 est par exemple formé d'une bande d'un matériau thermiquement conducteur, une première et une seconde extrémités de ladite bande étant en contact thermique, respectivement avec la première carte électronique 14 et avec la deuxième surface 36. Le drain thermique 42 est par exemple réalisé en cuivre ou en aluminium.

Le contact thermique entre la première carte électronique 14 et le drain thermique 42 est par exemple assuré par une couche 44 de pâte ou de mousse thermiquement conductrice, de type « gap pad ».

De manière optionnelle, entre ses deux extrémités, le drain thermique 42 est recouvert d'une gaine thermiquement isolante à la convection et/ou au rayonnement. De manière optionnelle, une feuille de graphite est collée sur le drain thermique 42 pour renforcer la conduction thermique entre la première carte électronique 14 et la deuxième surface 36.

On considère que la deuxième carte électronique 16 a des fonctions lui permettant d'être située à distance des équipements électriques 12. Ladite deuxième carte électronique 16 est donc disposée proche de, ou fixée à, la deuxième surface 36 du panneau de refroidissement 22, 122.

De manière optionnelle, le module 10, 110 comporte au moins une paroi thermiquement isolante 46, disposée entre la deuxième carte électronique 16 et un équipement électrique 12. De préférence, une face 48 de ladite paroi, orientée vers l'équipement électrique 12, est recouverte d'une couche d'un matériau déflecteur de rayonnement infrarouge.

Dans le cas où le module 10, 110 comporte une paroi thermiquement isolante 46, il n'est pas nécessaire de prévoir un contact physique entre la deuxième carte électronique 16 et la deuxième surface 36. En effet, l'air environnant la deuxième carte électronique 16 est refroidi par la deuxième surface 36 et reste au moins partiellement isolé de l'air environnant la première carte électronique 14, ce qui fournit un environnement plus frais à la deuxième carte électronique 16.

Un procédé de fonctionnement du module 10, 110 va maintenant être décrit. Les équipements électriques 12 en fonctionnement émettent une chaleur importante. Cette chaleur se diffuse dans le panneau 22, 122 au niveau de la première surface 34, puis est évacuée par les ailettes 24. Une partie de cette chaleur contribue cependant, par rayonnement et/ou convection, à réchauffer l'air environnant la première carte électronique 14. Lors du fonctionnement des équipements électriques 12, la première surface 34, dite « zone chaude », a une température plus élevée que la deuxième surface 36, dite « zone froide ».

Par ailleurs, le bus barre 18, disposé au-dessus de la première carte électronique 14, crée un confinement d'air chaud autour de ladite carte.

Le contact thermique entre ladite deuxième surface 36 et les première 14 et deuxième 16 cartes électroniques, comme décrit ci-dessus, permet de refroidir efficacement lesdites cartes électroniques 14, 16. La deuxième carte électronique 16 est en outre protégée du rayonnement thermique des équipements électriques 12 par la paroi thermiquement isolante 46.

L'exposition des cartes électroniques 14, 16 à la chaleur émise par les équipements électriques 12 est ainsi limitée, ce qui prolonge la durée de vie desdites cartes.

## Revendications

1. Module de puissance (10, 110) comprenant :
- des équipements électriques (12),
- au moins une première (14) et une deuxième (16) cartes électroniques, et
- un dispositif de refroidissement (20, 120), propre à évacuer de la chaleur dissipée par lesdits équipements électriques et cartes électroniques ;
**caractérisé en ce que** :
- le dispositif de refroidissement comporte une première (34) et une deuxième (36) surfaces thermiquement isolées l'une de l'autre, les équipements électriques (12) étant en contact thermique avec la première surface et à l'écart de la deuxième surface ;
- la première carte électronique (14) est fixée à un équipement électrique (12), ladite première carte électronique étant thermiquement reliée à la deuxième surface (36) du dispositif de refroidissement par un drain thermique (42) ; et
- la deuxième carte électronique (16) est disposée proche de la deuxième surface (36) du dispositif de refroidissement ou au contact de ladite deuxième surface.

2. Module de puissance selon la revendication 1, dans lequel les première (34) et deuxième (36) surfaces du dispositif de refroidissement sont sensiblement coplanaires.

3. Module de puissance selon la revendication 2, dans lequel le dispositif de refroidissement comporte :
- un panneau de refroidissement (22, 122), une première face (30) dudit panneau formant les première et deuxième surfaces du dispositif de refroidissement ; et
- des ailettes de ventilation (24, 26), fixées à une seconde face (32) du panneau de refroidissement.

4. Module de puissance (10) selon la revendication 3, dans lequel chacune des première (34) et deuxième (36) surfaces est formée d'un matériau thermiquement conducteur, le panneau de refroidissement (22) comportant en outre une bande (38) d'un matériau thermiquement isolant, séparant lesdites première et deuxième surfaces.

5. Module de puissance (110) selon la revendication 3, dans lequel le panneau de refroidissement (122) comporte au moins une fente (140) séparant les première (34) et deuxième (36) surfaces, lesdites première et deuxième surfaces étant reliées l'une à l'autre au niveau des extrémités de ladite fente.

6. Module de puissance selon l'une des revendications précédentes, dans lequel le drain thermique (42) comporte une bande d'un matériau thermiquement conducteur, une première et une seconde extrémités de ladite bande étant en contact thermique, respectivement avec la première carte électronique (14) et avec la deuxième surface (36).

7. Module de puissance selon la revendication 6, dans lequel un contact thermique entre la première carte électronique (14) et la première extrémité du drain thermique (42) est assuré par une couche (44) de pâte ou de mousse thermiquement conductrice.

8. Module de puissance (10) selon l'une des revendications précédentes, comportant au moins une paroi thermiquement isolante (46) disposée entre la deuxième carte électronique (16) et un équipement électrique (12).

9. Module de puissance selon la revendication 8, dans lequel une face (48) de la paroi thermiquement isolante, orientée vers l'équipement électrique (12), est recouverte d'une couche d'un matériau déflecteur de rayonnement infrarouge.

## Patentansprüche

1. Leistungsmodul (10, 110), aufweisend:
- elektrische Einrichtungen (12),
- wenigstens eine erste (14) und eine zweite (16) elektronische Karte und
- eine Kühlvorrichtung (20, 120), die imstande ist, die Wärme abzuziehen, die von den besagten elektrischen Einrichtungen und den elektronischen Karten abgegeben wird,
**dadurch gekennzeichnet, dass**
- die Kühlvorrichtung eine erste (34) und eine zweite (36) Fläche aufweist, die thermisch voneinander isoliert sind, wobei die elektrischen Einrichtungen (12) in thermischem Kontakt sind mit der ersten Fläche und im Abstand sind von der zweiten Fläche,
- die erste elektronische Karte (14) an einer elektrischen Einrichtung (12) befestigt ist, wobei die besagte erste elektronische Karte über einen thermischen Drain (42) mit der zweiten Fläche (36) der Kühlvorrichtung thermisch verbunden ist, und
- die zweite elektronische Karte (16) nahe der zweiten Fläche (36) der Kühlvorrichtung oder im Kontakt mit der besagten zweiten Fläche angeordnet ist.

2. Leistungsmodul gemäß Anspruch 1, wobei die erste (34) und die zweite (36) Fläche der Kühlvorrichtung im Wesentlichen komplanar sind.

3. Leistungsmodul gemäß Anspruch 2, wobei die Kühlvorrichtung aufweist:
- eine Kühlplatte (22, 122), wobei eine erste Seite (30) der besagten Kühlplatte die erste und die zweite Fläche der Kühlvorrichtung bildet, und
- Ventilationsrippen (24, 26), die an einer zweiten Seite (32) der Kühlplatte befestigt sind.

4. Leistungsmodul (10) gemäß Anspruch 3, wobei jede von der ersten (34) und der zweiten (36) Fläche aus einem thermisch leitenden Material gebildet ist, wobei die Kühlplatte (22) ferner einen Streifen (38) aus einem thermisch isolierenden Material aufweist, der die besagte erste und zweite Fläche separiert.

5. Leistungsmodul (110) gemäß Anspruch 3, wobei die Kühlplatte (122) aufweist wenigstens einen Spalt (140), der die erste (34) und die zweite (36) Fläche trennt, wobei die erste und die zweite Fläche auf Höhe der Enden des besagten Spalts miteinander verbunden sind.

6. Leistungsmodul gemäß einem der vorhergehenden Ansprüche, wobei der thermische Drain (42) einen Streifen aus einem thermisch leitenden Material aufweist, wobei ein erstes und ein zweites Ende des besagten Streifens in thermischem Kontakt sind respektive mit der ersten elektronischen Karte (14) und mit der zweiten Fläche (36).

7. Leistungsmodul gemäß Anspruch 6, wobei ein thermischer Kontakt zwischen der ersten elektronischen Karte (14) und dem ersten Ende des thermischen Drains (42) gewährleistet wird durch eine Schicht (44) aus thermisch isolierender/isolierendem Paste oder Schaum.

8. Leistungsmodul (10) gemäß einem der vorhergehenden Ansprüche, aufweisend wenigstens eine thermisch isolierende Wand (46), die zwischen der zweiten elektronischen Karte (16) und einer elektrischen Einrichtung (12) angeordnet ist.

9. Leistungsmodul gemäß Anspruch 8, wobei eine Seite (48) der thermisch isolierenden Wand, die hin zu der elektrischen Einrichtung (12) gewandt ist, von einer Schicht aus einem Infrarotstrahlung-Deflektor-Material bedeckt ist.

## Claims

1. A power module (10, 110), comprising:
- pieces of electrical equipment (12),
- at least first (14) and second (16) electronic cards, and
- a cooling device (20, 120), able to discharge heat given off by said pieces of electrical equipment and electronic cards;
**characterized in that**:
- the cooling devices include first (34) and second (36) surfaces thermally insulated from one another, the pieces of electrical equipment (12) being in thermal contact with the first surface and separated from the second surface;
- the first electronic card (14) is fastened to a piece of electrical equipment (12), said first electronic card being thermally connected to the second surface (36) of the cooling device by a heat sink (42); and
- the second electronic card (16) is positioned close to the second surface (36) of the cooling device or in contact with said second surface.

2. The power module according to claim 1, wherein the first (34) and second (36) surfaces of the cooling device are substantially coplanar.

3. The power module according to claim 2, wherein the cooling device includes:
- a cooling panel (22, 122), a first face (30) of said panel forming the first and second surfaces of the cooling device; and
- ventilation fins (24, 26), fastened to a second face (32) of the cooling panel.

4. The power module (10) according to claim 3, wherein each of the first (34) and second (36) surfaces is made from a thermally conducting material, the cooling panel (22) further including a strip (38) of thermally insulating material, separating said first and second surfaces.

5. The power module (110) according to claim 3, wherein the cooling panel (122) includes at least one slit (140) separating the first (34) and second (36) surfaces, said first and second surfaces being connected to one another at the ends of said slit.

6. The power module according to one of the preceding claims, wherein the heat sink (42) includes a strip of a thermally conducting material, first and second ends of said strip being in thermal contact, respectively with the first electronic card (14) and with the second surface (36).

7. The power module according to claim 6, wherein a thermal contact between the first electronic card (14) and the first end of the heat sink (42) is provided by a layer (44) of thermally conductive paste or foam.

8. The power module (10) according to one of the preceding claims, including at least one thermally insulating wall (46) positioned between the second electronic card (16) and a piece of electrical equipment (12).

9. The power module according to claim 8, wherein a face (48) of the thermally insulating wall, oriented toward the piece of electrical equipment (12), is covered by a layer of material deflecting infrared radiation.
